# EUROPÄISCHE PATENTSCHRIFT

(11) **EP 0 685 117 B1**
(45) Veröffentlichungstag und Bekanntmachung des Hinweises auf die Patenterteilung: **04.09.1996**
(21) Anmeldenummer: 94907553.5
(22) Anmeldetag: 11.02.1994
(51) Int. Cl.: H01L 33/00, H05H 1/00

(54) **VERFAHREN UND ANORDNUNG ZUR PLASMA-ERZEUGUNG**
PLASMA GENERATING PROCESS AND ARRANGEMENT
PROCEDE ET AGENCEMENT POUR LA PRODUCTION DE PLASMA

(30) Priorität: 17.02.1993 DE 4304846; 06.05.1993 DE 4315075
(43) Veröffentlichungstag der Anmeldung: 06.12.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: LANG, Walter, D-81371 München (DE); KOZLOWSKI, Frank, D-82284 Grafrath (DE); RICHTER, Axel, D-81379 München (DE); SAUTER, Martin, D-80805 München (DE); STEINER, Peter, D-86529 Schrobenhausen (DE)
(74) Vertreter: Schoppe, Fritz, Dipl.-Ing.
(86) Internationale Anmeldenummer: EP9400400
(87) Internationale Veröffentlichungsnummer: WO9419832

(56) Entgegenhaltungen:
- WO-A-92/19084
- WO-A-93/04503
- APPLIED PHYSICS LETTERS, Bd. 60, Nr. 3, 20. Januar 1992, New York US, Seiten 347-349, XP297660; N. KOSHIDA et al.: 'Visible electroluminescence from porous silicon'
- PATENT ABSTRACTS OF JAPAN vol. 17, no. 325 (E-1384) 21. Juni 1993 & JP-A-05 037 012
- APPLIED PHYSICS LETTERS, Bd. 62, Nr. 7, 15. Februar 1993, New York US, Seiten 708-710, XP338307; Zhiliang CHEN et al.: 'Visible light emission from heavily doped porous silicon homojunction pn diodes'
- APPLIED PHYSICS LETTERS, Bd. 60, Nr. 5, 3. Februar 1992, New York US, Seiten 619-620, XP295606; V.V. DOAN et al.: 'Photolithographic fabrication of micron-dimension porous Si structures exhibiting visible luminescence'
- EXTENDED ABSTRACTS OF THE 1992 INT. CONF. ON SOLID STATE DEVICES & MATERIALS, Tsukuba JP, 26-28 August 1992, Seiten 387-388; Xun WANG et al.: 'Improvement of electroluminescent efficiency of light-emitting porous silicon'
- APPLIED PHYSICS LETTERS, Bd. 57, Nr. 10, 3. September 1990, New York US, Seiten 1046-1048, XP164512; L.T. CANHAM : 'Silicon quantum wire array fabrication by electrochemical and chemical dissolution of wafers'

## Beschreibung

Die vorliegende Erfindung befaßt sich mit einem Verfahren sowie einer Anordnung zur Plasma-Erzeugung.

Ein Gas, dessen Eigenschaften wesentlich durch die Existenz positiver und negativer Ionen, aber auch freier Elektronen bestimmt werden, bezeichnet man als Plasma. Die Plasma-Erzeugung ist üblicherweise mit einem sehr hohen apparativen Aufwand verbunden. Eine typische Anordnung besteht beispielsweise aus einer Röhre, in der ein Edelgas mit niedrigem Druck enthalten ist, über das durch eine Kathode und eine Anode eine hohe Spannung angelegt wird. Typischerweise ist noch eine zusätzliche Zündvorrichtung vorgesehen. Derartige Vorrichtungen sind nicht nur technisch aufwendig, sondern auch verhältnismäßig voluminös.

Ausgehend von diesem Stand der Technik liegt der Erfindung daher die Aufgabe zugrunde, ein vereinfachtes Verfahren sowie eine vereinfachte Anordnung zur Plasma-Erzeugung anzugeben.

Der Erfindung liegt die verblüffende Erkenntnis zugrunde, daß es bei Anlegen einer Spannung an zwei voneinander beabstandeten Punkten eines mikroporösen Körpers innerhalb des mikroporösen Körpers zur Erzeugung von Plasmen kommt. Wie noch im einzelnen erläutert wird, wurde dieses Phänomen besonders ausgeprägt bei Anlegung einer verhältnismäßig geringen Gleichspannung von etwa 50 bis 80 Volt an zwei voneinander beabstandete Punkte eines mit einer mikroporösen Schicht versehenen Silizium-Wafers beobachtet. Bei Anlegen einer Spannung an einen mikroporösen Körper, wie beispielsweise an einen mikroporösen Siliziumkörper, strahlt dieser aufgrund der in seinem Inneren erzeugten Plasmen ultraviolettes Licht ab.

In jüngerer Zeit wurden zwar schon verschiedene Untersuchungen an mikroporösen Materialien, wie beispielsweise mikroporösem Silizium durchgeführt, die erwiesen haben, daß bei solchen Materialien bislang nicht für möglich gehaltene photolumineszente Wirkungen auftreten. Nur beispielsweise wird verwiesen auf L.T. Canham, Appl. Phys. Lett. 57 (10), 3. September 1990, Seiten 1046 bis 1048. In dieser Fachveröffentlichung wird berichtet, daß bei mikroporösen Siliziumschichten mit Porenweiten von weniger als 2 nm eine Beschränkung der Elektronenbeweglichkeit auf eine Dimension stattfindet, so daß man bei derartigen Materialien von der Ausbildung von sog. "Quantendrähten" spricht. Diese Quantenleiter oder Quantendrähte bewirken durch die Einschränkung der Bewegungsmöglichkeit der Elektronen einen direkten Übergang der Elektronen zwischen dem Leitungsband und dem Valenzband, obwohl es sich bei Silizium an sich um ein Halbleitermaterial mit indirektem Bandübergang handelt. Die mikroporöse Struktur der hier untersuchten Siliziumelemente wird typischerweise dadurch erreicht, daß ein Silizium-Wafer in einer wässrigen Flußsäure anodisiert wird. In diesem Zusammenhang wird hingewiesen auf die Veröffentlichung "Silicon Lights Up", Scientific American, Juli 1991, Seiten 86 und 87.

Es sei jedoch betont, daß bislang bei derartigen mikroporösen Strukturen lediglich eine zeitlich nicht stabile Photolumineszenz erzielt wurde.

In der Fachveröffentlichung APPLIED PHYSICS LETTERS, Band 60, Nr. 5, 3.2.1992, New York US, Seiten 619 und 620; v.v. Doan und M.J.Sailor: "Photolitographic fabrication of micron-dimension porous Si structures exhibiting visible luminescence" ist die Herstellung eines Siliziumwafers mit einer mikroporösen Siliziumschicht beschrieben. Der Siliziumwafer wird in ein Ätzbad eingetacuht, das je zur Hälfte aus wässriger Flußsäurelösung einerseits und Äthenol andererseits besteht. An einem derartigen mikroporösen Siliziumkörper wurde bei Bescheinen mit einer Quecksilberlampe Photolumineszenz nachgewiesen. Gleichfalls wurde eine Photolumineszenz durch Erregung mittels eines He-Cd-Lasers erreicht.

Die WO 92/19084 beschreibt eine Siliziumstruktur mit einer porösen Siliziumschicht, die durch Beleuchten mittels ultravioletter Strahlung zu Photolumineszenz angeregt werden kann. Gleichfalls wird bei Kontaktierung sowohl des Siliziumgrundkörpers einerseits wie auch der mikroporösen Siliziumschicht andererseits die Erzeugung von Elektrolumineszenz beschrieben.

Nachfolgend werden unter Bezugnahme auf die beiliegenden Zeichnungen eine bevorzugte Ausführungsform der Anordnung zur Plasma-Erzeugung sowie des Verfahrens zur Plasma-Erzeugung näher erläutert. Es zeigen:
- Fig. 1: eine Vorrichtung zur Erzeugung eines mikroporösen Körpers zur Verwendung in einer bevorzugten Ausführungsform der Anordnung zur Plasma-Erzeugung nach einer Ausführungsform der Erfindung;
- Fig. 2: ein Ausführungsbeispiel einer Anordnung zur Plasma-Erzeugung nach dieser Ausführungsform der Erfindung;
- Fig. 3: das von der Anordnung zur Plasma-Erzeugung abgegebene Spektrum.

Erfindungsgemäß wird ein Plasma dadurch erzeugt, daß ein mikroporöser Körper geschaffen wird, woraufhin an den mikroporösen Körper an zwei voneinander beabstandeten Punkten des Körpers eine Spannung angelegt wird.

Eine besonders einfache Plasmaanregung wird erreicht, wenn der mikroporöse Körper vernetzte Poren hat, deren Porendurchmesser zwischen 1 nm und 50 µm, vorzugsweise zwischen 10 nm und 10 µm beträgt. Eine besonders einfache Anregung der Plasma-Erzeugung wird bei solchen mikroporösen Körpern beobachtet, die sowohl große als auch kleine Poren aufweisen, deren Durchmesser sich um mehr als den Faktor 2 voneinander unterscheidet.

Ein besonders bevorzugter Werkstoff zum Erzeugen eines solchen mikroporösen Körpers ist jegliches Halbleitermaterial.

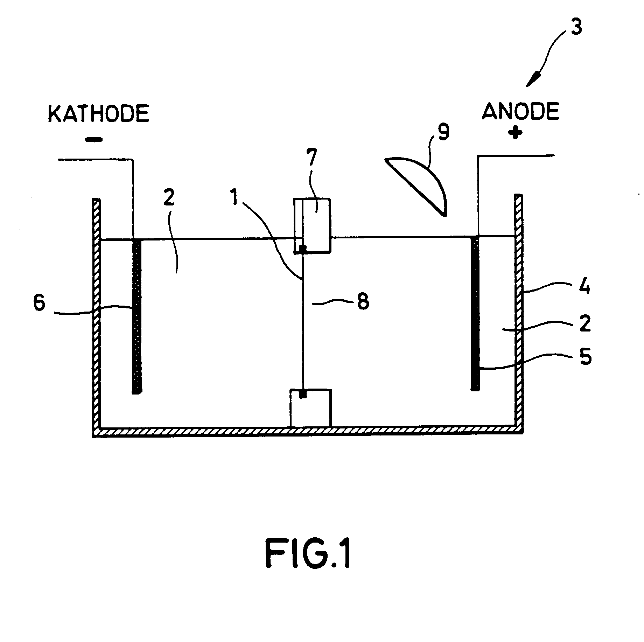

Wie nachfolgend unter Bezugnahme auf Fig. 1 erläutert werden wird, kann ein mikroporöses Halbleitermaterial in besonders einfacher Weise dadurch geschaffen werden, daß ein Silizium-wafer 1 in ein Säurebad 2 eingebracht und dort anodisiert wird.

Eine Herstellungsvorrichtung 3 für einen mikroporösen Siliziumkörper umfaßt ein Säurebecken 4, in dem das Säurebad 2 enthalten ist, welches 2 bis 50 Gewichtsprozent Flußsäure und im übrigen Äthanol und Wasser enthält. In dem Säurebad 2 sind in sich gegenüberliegender, voneinander beabstandeter Anordnung eine Anode 5 und eine Kathode 6 eingetaucht, welche mit einem Anodisierungsstrom beaufschlagt werden können.

Eine Haltevorrichtung 7 ist an ihrer Peripherie derart ausgestaltet, daß sie dichtend an den Wandungen des Säurebekkens 4 anliegt, wenn sie von oben in das Säurebecken 4 eingeschoben ist. Die Haltevorrichtung 7 weist eine mittige Ausnehmung 8 auf, an deren Ort der Silizium-Wafer 1 in einer an seinen Randbereichen dichtend umschlossenen Art gehalten ist.

Die Anordnung der Haltevorrichtung 7 ist dergestalt, daß ein Stromfluß zwischen der Anode 5 und der Kathode 6 den Silizium-Wafer 1 vertikal zu dessen Hauptflächen durchlaufen muß.

Eine Beleuchtungsvorrichtung 9 in Form einer Quecksilberlampe oder Halogenlampe ist derart oberhalb des Säurebades 2 oder bei säurefester Ausführung der Beleuchtungsvorrichtung 9 innerhalb des Säurebades 2 angeordnet, daß der Silizium-Wafer 1 von seiner anodischen Seite her beleuchtet wird. Bei Anordnung der Beleuchtungsvorrichtung 9 außerhalb des Säurebeckens 4 ist es bevorzugt, in diesem ein (nicht gezeigtes) Fenster für den Lichtdurchtritt vorzusehen. Auch kann bei Anordnung der Beleuchtungsvorrichtung 9 oberhalb des Säurebeckens 4 in dem Säurebad 2 ein Spiegel zur Umlenkung der Strahlen zu dem Wafer 1 hin vorgesehen sein. Die Beleuchtungsvorrichtung 9 kann auch ein Laser sein. In diesem Fall wird man bevorzugt einen Argon-Ionen-Laser mit einer Wellenlänge von 488 nm bei einer Flächenleistungsdichte von 5 W/cm² einsetzen.

Nach Einbringen des Silizium-Wafers 1 in die Haltevorrichtung 7 wird diese von oben in das Säurebecken 4 eingeschoben. Nun wird der Silizium-Wafer 1 durch Anlegen eines entsprechenden Gleichstromes an Anode 5 und Kathode 6 mit einer Stromdichte von 2 bis 500 mA/cm² anodisiert, wobei der Silizium-Wafer 1 an einer seiner Hauptflächen eine Umwandlung des einkristallinen Siliziums in eine mikroporöse Siliziumschicht 10 erfährt. Typische Anodisierungs- und Beleuchtungszeiten liegen zwischen 10 Sekunden und 20 Minuten.

Nach dem Spülen des Silizium-Wafers 1 in Reinstwasser wird dieser mit einem rückseitigen ohmschen Kontakt 11 sowie mit einer vorderseitigen transparenten Elektrode 12 versehen. Die vorderseitige Elektrode 12 wird vorzugsweise durch Aufbringen eines Goldkontaktes mit 120 nm Dicke oder durch Aufbringen einer Indium-Zinn-Oxid-Schicht mit 200 nm Dicke realisiert werden.

Obwohl dies, wie noch erläutert werden wird, für die Erreichung der erfindungsgemäßen Effekte nicht zwingend ist, wird man in der Praxis in der Regel einen kleinen n-dotierten Silizium-Wafer verwenden, dessen spezifischer Widerstand zwischen 1 und 10 Ω cm beträgt.

Der Silizium-Wafer 1 kann, wenn dies erwünscht ist, durch entsprechendes Zerteilen in einzelne Elemente unterteilt werden, die abgesehen von ihrer Gehäusung nunmehr fertiggestellt sind.

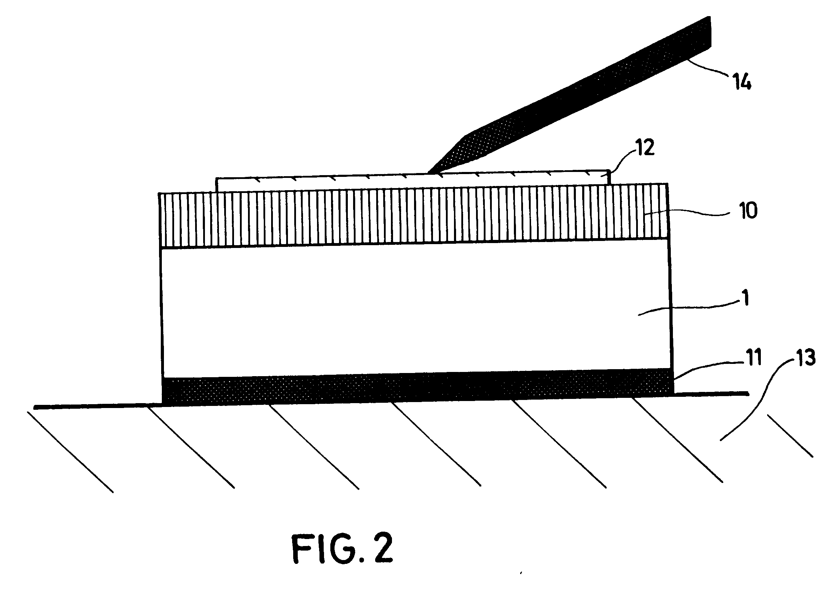

Wie in Fig. 2 gezeigt ist, wird das so gebildete Siliziumelement 1 mit dem ohmschen Kontakt 11 auf eine leitende Fläche 13 aufgelegt, die beispielsweise eine Metallplatte sein kann. Diese leitende Fläche bildet eine erste Elektrode. Eine zweite Elektrode 14, die beispielsweise eine stiftförmige Elektrode sein kann, wird von oben gegen die transparente Elektrode 12 zur Anlage gebracht, woraufhin eine Gleichspannung oder Wechselspannung in der Größenordnung zwischen 50 und 100 V an das Siliziumelement angelegt wird.

Wesentlich ist es für die Erfindung, daß bei Verwendung eines porösen Siliziums die angelegt Spannung größer als diejenige Spannung ist, bei der Elektrolumineszenz auftritt. Typisch sind Spannungen oberhalb 50 V.

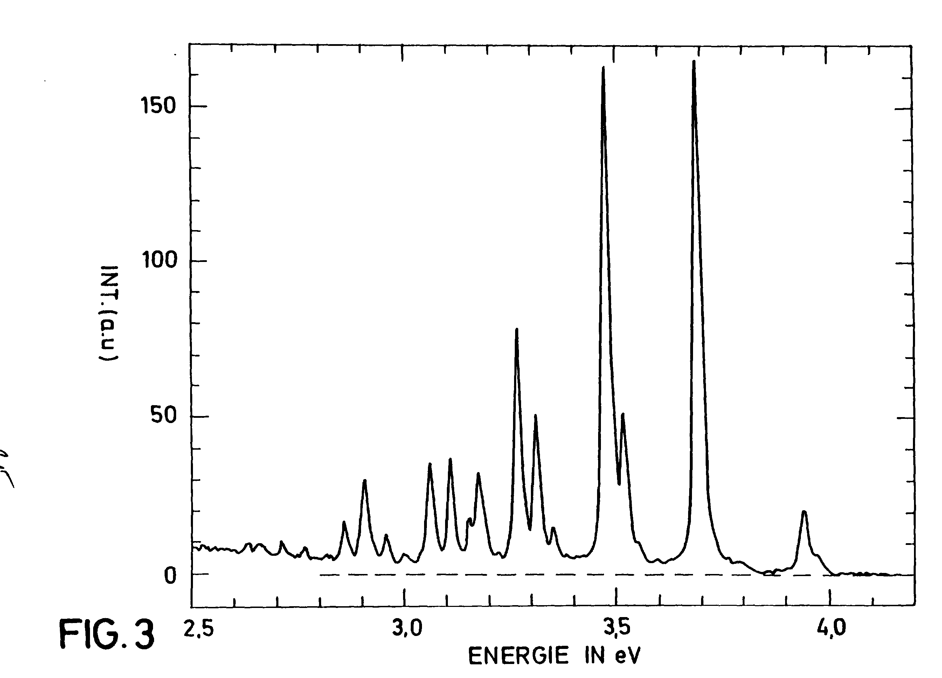

Das sich nun ergebende Spektrum ist in Fig. 3 wiedergegeben, wobei anstelle der üblichen Angabe der abgegebenen Wellenlänge hier die Energie in eV dargestellt ist. Die abgegebene Intensität, die in y-Richtung aufgetragen ist, ist nicht normiert.

Man erkennt Spitzenwerte der Kurve im ultravioletten Bereich, die die interne Erzeugung von Plasmen innerhalb der mikroporösen Schicht 10 des Siliziumelementes 1 belegen.

Das in Fig. 2 gezeigte Siliziumelement 1 stellt lediglich eine der möglichen Grundstrukturen eines für eine Plasma-Erzeugung denkbaren Körpers dar. Bereits in dieser Grundstruktur kann das in Fig. 2 gezeigte Siliziumelement als UV-Lichtquelle verwendet werden.

In Abweichung von der in Fig. 2 gezeigten Struktur des Siliziumelementes kann eine phosphorisierende Schicht oberhalb des mikroporösen Siliziums 10 aufgebracht bzw. abgeschieden werden, so daß das so gebildete Element in der Lage ist, als Lichtquelle für sichtbares Licht zu arbeiten.

In unveränderter Form kann das gezeigte Element als Eichlampe für UV-Linien verwendet werden.

Es ist möglich, Metall-Ionen in die mikroporöse Schicht 10 einzubringen, die innerhalb des erzeugten Plasmas leuchten. Nur beispielsweise seien hier Br und Na erwähnt.

Ein möglicher Anwendungsfall der erfindungsgemäßen Anordnung zur Plasma-Erzeugung betrifft Laserpumpen.

Die beschriebene Ausführungsform der Anordnung zur Plasma-Erzeugung kann auch als Mikroquelle für Ozon eingesetzt werden, wobei man in diesem Fall den mikroporösen Bereich mit Luft oder Sauerstoff beströmen wird.

Ebenfalls kann die erfindungsgemäße Plasma-Erzeugungsanordnung aufgrund ihrer Mikrominiaturisierbarkeit als Mikroreaktionszelle eingesetzt werden, in welche in einem Mikrosystem eine chemische Reaktion im Plasma stattfindet.

Auf der Grundlage des so gebildeten Plasma-Erzeugungselementes können Sensoren aufgebaut werden, da die Wellenlänge der UV-Strahlung abhängig von der Gaszusammensetzung ist, so daß Gassensoren gebildet werden können, abhängig vom Druck ist, so daß Drucksensoren gebildet werden können, abhängig von der Temperatur ist, so daß Temperatursensoren gebildet werden können, sowie abhängig von magnetischem und elektrischem Feld ist, so daß entsprechende Feldsensoren gebildet werden können.

Bei dem bevorzugten Ausführungsbeispiel wird mikroporöses Silizium dadurch gebildet, daß dies in einem Flußsäurebad anodisiert und gleichzeitig beleuchtet wird. Eine mikroporöse Schicht kann bei verlängerten Reaktionszeiten auch ohne Beleuchtung durch Anodisieren im Flußsäurebad erzeugt werden.

Der mikroporöse Körper muß nicht nötigerweise aus Silizium bestehen. Neben anderen porösen Halbleitermaterialien kommen jegliche porösen Stoffe in Betracht, wenn diese nicht gerade sehr gute Leiter oder sehr gute Isolatoren sind, da es in dem erstgenannten Fall nicht möglich ist, innerhalb der Mikroporen die nötigen Feldstärken aufzubauen, und da es im zweitgenannten Fall nicht möglich ist, die zum Erhalt der Plasmen nötigen Ströme fließen zu lassen. Es wird als bevorzugt angesehen, daß der mikroporöse Körper einen spezifischen Widerstand größer als 2 · 10⁻⁷ Ω · m hat.

Besonders gute Ergebnisse erreicht man dann, wenn der mikroporöse Körper vernetzte Poren hat. Als bevorzugt werden hier Strukturen mit Poren unterschiedlichen Durchmessers zwischen 1 nm und 50 µm, vorzugsweise 10 nm und 10 µm angesehen.

Auch wenn man, wie dies bei dem bevorzugten Ausführungsbeispiel der Fall ist, ein mikroporöses Halbleitermaterial als mikroporösen Körper einsetzt, ist es nicht zwingend erforderlich, dieses durch Anodisieren eines Wafers in Flußsäure zu erzeugen. Gleichfalls kann man einen Halbleiterwafer in einem Bad aus Flußsäure und einem Oxidationsmittel, das beispielsweise HNO₂ sein kann, zumindest im Bereich seiner Oberfläche in eine mikroporöse Form bringen.

Abschließend sei angemerkt, daß im Sinne der vorliegenden Anmeldung Porenstrukturen unterhalb von 50 µm als mikroporös zu verstehen sind.

## Patentansprüche

1. Verfahren zur Plasma-Erzeugung, mit folgenden Verfahrensschritten:
- Bereitstellen eines mikroporösen Körpers,
-- der einen spezifischen Widerstand größer als 2·10⁻⁷ ohm·m hat und
-- der mit einem Gas gefüllte Poren aufweist, die einen Porendurchmesser zwischen 1 Nanometer und 50 Mikrometer haben,
- Erzeugen zweier voneinander beabstandeter Kontakte, mit denen eine zur Plasmaerzeugung ausreichende Spannung an den mikroporösen Körper anlegbar ist, und
- Anlegen einer zur Plasma-Erzeugung ausreichenden Spannung, die größer ist als die Spannung, bei der Elektrolumineszenz auftritt, an die Kontakte.

2. Verfahren nach Anspruch 1, dadurch gekennzeichnet,
daß der mikroporöse Körper vernetzte Poren hat.

3. Verfahren nach Anspruch 1 oder 2, dadurch gekennzeichnet,
daß der mikroporöse Körper Poren aufweist, die einen Porendurchmesser zwischen 10 Nanometer und 10 Mikrometer haben.

4. Verfahren nach einem der Ansprüche 1 bis 3, dadurch gekennzeichnet,
daß der mikroporöse Körper sowohl große als auch kleine Poren aufweist, deren Durchmesser sich um mehr als den Faktor 2 voneinander unterscheiden.

5. Verfahren nach einem der Ansprüche 1 bis 4, dadurch gekennzeichnet,
daß der mikroporöse Körper aus einem porösen Halbleitermaterial besteht.

6. Verfahren nach Anspruch 5, dadurch gekennzeichnet,
daß der mikroporöse Körper aus mikroporösem Silizium besteht.

7. Verfahren nach Anspruch 6, dadurch gekennzeichnet,
daß der Verfahrensschritt des Bereitstellens des mikroporösen Siliziums folgende Teilschritte umfaßt:
- Einbringen eines Silizium-Wafers in ein Säurebad, und
- Anodisieren des Silizium-Wafers in dem Säurebad.

8. Verfahren nach Anspruch 7, gekennzeichnet durch folgenden zusätzlichen Teilschritt zur Bereitstellung des mikroporösen Siliziums:
- Beleuchten des Silizium-Wafers auf dessen anodischer Seite zumindest über einen Teil der Zeit, während der der Silizium-Wafer in das Säurebad eingebracht ist und anodisiert wird, wodurch das einkristalline Silizium des Silizium-Wafers zumindest bereichsweise in eine mikroporöse Siliziumschicht umgewandelt wird.

9. Verfahren nach einem der Ansprüche 7 oder 8, dadurch gekennzeichnet,
daß das Anodisieren mit einer Stromdichte von 2 bis 500 mA/cm² erfolgt.

10. Verfahren nach einem der Ansprüche 7 bis 9, dadurch gekennzeichnet,
daß das Säurebad 2 bis 50 Gewichtsprozent Flußsäure enthält und im übrigen aus Äthanol und Wasser besteht.

11. Verfahren nach einem der Ansprüche 7 bis 9, dadurch gekennzeichnet,
daß der Silizium-Wafer n-dotiert ist.

12. Verfahren nach Anspruch 11, dadurch gekennzeichnet,
daß die Dotierung des Silizium-Wafers derart gewählt ist, daß dessen spezifischer Widerstand zwischen 1 und 10 Ohm cm beträgt.

13. Verfahren nach einem der Ansprüche 8 bis 12, dadurch gekennzeichnet,
daß die Beleuchtung mit einer Quecksilberlampe oder einer Halogenlampe oder einem Laser erfolgt.

14. Verfahren nach einem der Ansprüche 7 bis 13, dadurch gekennzeichnet,
daß der Verfahrensschritt des Erzeugens des zweiten Kontaktes das Erzeugen eines ohmschen Kontaktes auf der Rückseite des Silizium-Wafers umfaßt.

15. Verfahren nach einem der Ansprüche 7 bis 14, dadurch gekennzeichnet,
daß der Verfahrensschritt des Erzeugens des ersten Kontaktes das Aufbringen eines Goldkontaktes umfaßt.

16. Verfahren nach Anspruch 15, dadurch gekennzeichnet,
daß die Dicke des Goldkontaktes etwa 120 Nanometer beträgt.

17. Verfahren nach einem der Ansprüche 7 bis 16, dadurch gekennzeichnet,
daß der Verfahrensschritt des Erzeugens des ersten Kontaktes das Aufbringen einer Indium-Zinn-Oxid-Schicht umfaßt.

18. Verfahren nach Anspruch 17, dadurch gekennzeichnet,
daß die Dicke der Indium-Zinn-Oxid-Schicht etwa 200 Nanometer beträgt.

19. Verfahren nach einem der Ansprüche 7 bis 18, dadurch gekennzeichnet,
daß der Verfahrensschritt des Kontakterzeugens folgende Schritte umfaßt:
- Aufbringen eines zumindest teilweisen lichtdurchlässigen ersten Kontaktes auf die mikroporöse Siliziumschicht, und
- Erzeugen eines zweiten Kontaktes zur Kontaktierung eines Bereiches des Siiizium-Wafers unterhalb der mikroporösen Siliziumschicht.

20. Anordnung zur Plasma-Erzeugung, die folgende Bestandteile enthält:
- einen mikroporösen Körper (1,10),
-- der einen spezifischen Widerstand größer als 2·10⁻⁷ Ohm·m hat
-- der mit einem Gas gefüllte Poren aufweist, die einen Porendurchmesser zwischen 1 Nanometer und 50 Mikrometer haben, und
-- zwei voneinander beabstandete Kontakte (11,12) hat, mit denen eine zur Plasmaerzeugung ausreichende Spannung an den mikroporösen Körper (1,10) anlegbar ist,
- eine Spannungsquelle zum Anlegen einer zur Plasma-Erzeugung ausreichenden Spannung, die größer ist als die Spannung, bei der Elektrolumineszenz auftritt, an die Kontakte (11,12).

21. Anordnung nach Anspruch 20, dadurch gekennzeichnet,
daß der mikroporöse Körper (1,10) vernetzte Poren hat.

22. Anordnung nach Anspruch 20 oder 21, dadurch gekennzeichnet,
daß der mikroporöse Körper (1,10) Poren aufweist, die einen Porendurchmesser zwischen 10 Nanometer und 10 Mikrometer haben.

23. Anordnung nach einem der Ansprüche 20 bis 22, dadurch gekennzeichnet,
daß der mikroporöse Körper (1,10) sowohl große als auch kleine Poren aufweist, deren Durchmesser sich um mehr als den Faktor 2 voneinander unterscheiden.

24. Anordnung nach einem der Ansprüche 20 bis 23, dadurch gekennzeichnet,
daß der mikroporöse Körper (1,10) aus einem Halbleitermaterial besteht.

25. Anordnung nach Anspruch 24, dadurch gekennzeichnet,
daß der mikroporöse Körper (1,10) aus mikroporösem Silizium besteht.

26. Anordnung nach einem der Ansprüche 20 bis 25, dadurch gekennzeichnet
daß der Körper eine leitfähige Grundschicht (23), eine auf dieser (23) angeordnete Isolatorschicht (24) und eine auf der Isolatorschicht (24) angeordnete Gegenelektrodenschicht (25) aufweist,
daß sich die Poren (21) im Bereich der Oberfläche (22) des Körpers (20) befinden und sich ausgehend von der Oberfläche (22) des Körpers (20) durch die Gegenelektrodenschicht (25) und durch die Isolatorschicht (24) bis in die Grundschicht (23) erstrecken und
daß die Breite (B1) der Poren (21) in der Richtung parallel zu der Oberfläche (22) des Körpers (20) größer als die freie Weglänge der Elektronen und kleiner als das zwanzigfache der freien Weglänge der Elektronen ist, wobei die freie Weglänge der Elektronen von der Art und dem Druck des die Anordnung umgebenden Gases abhängt.

27. Anordnung nach Anspruch 26, dadurch gekennzeichnet,
daß die Tiefe (D2) der Poren (21) senkrecht zu der Oberfläche (22) größer ist als deren Breite (B1).

28. Anordnung nach Anspruch 26 oder 27, dadurch gekennzeichnet,
daß die Dicke (D1) der Isolatorschicht (24) in der Richtung senkrecht zu der Oberfläche (22) des Körpers (20) größer als die freie Weglänge der Elektronen und kleiner als die zwanzigfache freie Weglänge der Elektronen ist, wobei die freie Weglänge der Elektronen von der Art und dem Druck des die Anordnung umgebenden Gases abhängt.

29. Anordnung nach Anspruch 28, dadurch gekennzeichnet,
daß die Dicke (D1) der Isolatorschicht (24) in der Richtung senkrecht zu der Oberfläche (22) des Körpers (20) kleiner ist als die zehnfache freie Weglänge der Elektronen, wobei die freie Weglänge der Elektronen von der Art und dem Druck des die Anordnung umgebenden Gases abhängt.

30. Anordnung nach einem der Ansprüche 25 bis 29, dadurch gekennzeichnet,
daß die Poren (21) durch Anodisieren oder durch ein Ätzverfahren erzeugt sind.

31. Anordnung nach einem der Ansprüche 26 bis 30, dadurch gekennzeichnet,
daß die Dicke der Gegenelektrodenschicht (25) 0,1 µm bis 0,5 µm beträgt.

32. Anordnung nach einem der Ansprüche 26 bis 31, dadurch gekennzeichnet,
daß die Dicke der Isolatorschicht (24) 0,5 µm bis 5 µm beträgt.

33. Anordnung nach einem der Ansprüche 26 bis 33, dadurch gekennzeichnet,
daß das die Anordnung umgebende Gas Luft, Stickstoff oder ein Edelgas bei Umgebungsdruck ist, und
daß die Breite (B1) der Poren (21) zwischen 0,5 µm und 20 µm beträgt.

34. Anordnung nach einem der Ansprüche 26 bis 33, dadurch gekennzeichnet,
daß das die Anordnung umgebende Gas Luft, Stickstoff oder ein Edelgas ist, und
daß die Tiefe (D2) der Poren (21) zwischen 0,5 µm und 20 µm beträgt.

35. Anordnung nach einem der Ansprüche 26 bis 34, dadurch gekennzeichnet,
daß die leitfähige Grundschicht (23) aus einem Metall oder Halbleitermaterial besteht.

36. Anordnung nach Anspruch 35, dadurch gekennzeichnet,
daß die leitfähige Grundschicht (23) aus Silizium besteht.

37. Anordnung nach einem der Ansprüche 26 bis 36, dadurch gekennzeichnet,
daß die Isolatorschicht (24) aus SiO₂, N₃O₄, Al₂O₃ oder einem Kunststoff besteht.

38. Anordnung nach einem der Ansprüche 26 bis 37, dadurch gekennzeichnet,
daß die Gegenelektrodenschicht (25) aus Metall oder aus Polysilizium besteht.

39. Anordnung nach einem der Ansprüche 26 bis 38, dadurch gekennzeichnet,
daß die Porenwand zumindest im Bereich der leitfähigen Grundschicht (23) mit einer Isolationsschicht (28) bedeckt ist, deren Dicke kleiner oder gleich 1 µm ist.

## Claims

1. A method of generating plasma comprising the following method steps:
- providing a microporous body,
-- which has a specific resistance exceeding 2·10⁻⁷ Ohm·m and
-- which comprises pores filled with a gas, said pores having a pore diameter between 1 nanometer and 50 micrometers,
- producing two contacts arranged in spaced relationship with one another and used for applying to the microporous body a voltage which is sufficiently high for generating plasma, and
- applying to said contacts a voltage which is sufficiently high for generating plasma and which is higher than the voltage at which electroluminescence occurs.

2. A method according to claim 1, characterized in
that the microporous body has interconnected pores.

3. A method according to claim 1 or 2, characterized in
that the microporous body has pores having a pore diameter between 10 nanometers and 10 micrometers.

4. A method according to one of the claims 1 to 3, characterized in
that the microporous body comprises large as well as small pores whose diameters differ by more than the factor 2.

5. A method according to one of the claims 1 to 4, characterized in
that the microporous body consists of a porous semiconductor material.

6. A method according to claim 5, characterized in
that the microporous body consists of microporous silicon.

7. A method according to claim 6, characterized in
that the method step of providing the microporous silicon comprises the following substeps:
- introducing a silicon wafer into an acid bath, and
- anodizing the silicon wafer in said acid bath.

8. A method according to claim 7, characterized by the following additional substep for providing the microporous silicon:
- illuminating the silicon wafer on the anodic side thereof at least during part of the period of time for which the silicon wafer is introduced in the acid bath and anodized, whereby the monocrystalline silicon of the silicon wafer is converted into a microporous silicon layer at least in certain areas thereof.

9. A method according to one of the claims 7 or 8, characterized in
that the anodizing is carried out with a current density of 2 to 500 mA/cm².

10. A method according to one of the claims 7 to 9, characterized in
that the acid bath contains from 2 to 50 % by weight hydrofluoric acid and that the rest of the acid bath consists of ethanol and water.

11. A method according to one of the claims 7 to 9, characterized in
that the silicon wafer is n-doped.

12. A method according to claim 11, characterized in
that the doping of the silicon wafer is chosen such that the specific resistance thereof is between 1 and 10 Ohm · cm.

13. A method according to one of the claims 8 to 12, characterized in
that the illumination is carried out by means of a mercury lamp or a halogen lamp or a laser.

14. A method according to one of the claims 7 to 13, characterized in
that the method step of producing the second contact comprises the production of an ohmic contact on the back of the silicon wafer.

15. A method according to one of the claims 7 to 14, characterized in
that the method step of producing the first contact comprises the application of a gold contact.

16. A method according to claim 15, characterized in
that the thickness of the gold contact is approx. 120 nanometers.

17. A method according to one of the claims 7 to 16, characterized in
that the method step of producing the first contact comprises the application of an indium-tin oxide layer.

18. A method according to claim 17, characterized in
that the thickness of the indium-tin oxide layer is approx. 200 nanometers.

19. A method according to one of the claims 7 to 18, characterized in
the method step of producing the contacts comprises the following steps:
- applying an at leat partially light-transmitting first contact to the microporous silicon layer, and
- producing a second contact for contacting an area of the silicon wafer below the microporous silicon layer.

20. An arrangement for generating plasma which comprises the following components:
- a microporous body (1, 10),
-- which has a specific resistance exceeding 2·10⁻⁷ Ohm·m,
-- which comprises pores filled with a gas, said pores having a pore diameter between 1 nanometer and 50 micrometers, and
-- which has two contacts (11, 12) arranged in spaced relationship with one another and used for applying to the microporous body (1, 10) a voltage which is sufficiently high for generating plasma,
- a voltage source for applying to said contacts (11, 12) a voltage which is sufficiently high for generating plasma and which is higher than the voltage at which electroluminescence occurs.

21. An arrangement according to claim 20, characterized in
that the microporous body (1, 10) has interconnected pores.

22. An arrangement according to claim 20 or 21, characterized in
that the microporous body (1, 10) has pores having a pore diameter between 10 nanometers and 10 micrometers.

23. An arrangement according to one of the claims 20 to 22, characterized in
that the microporous body (1, 10) comprises large as well as small pores whose diameters differ by more than the factor 2.

24. An arrangement according to one of the claims 20 to 23, characterized in
that the microporous body (1, 10) consists of a semiconductor material.

25. An arrangement according to claim 24, characterized in
that the microporous body (1, 10) consists of microporous silicon.

26. An arrangement according to one of the claims 20 to 25, characterized in
that the body comprises a conductive bottom layer (23), an insulating layer (24) arranged on said bottom layer (23), and a counterelectrode layer (25) arranged on said insulating layer (24),
that the pores (21) are provided in the area of the surface (22) of the body (20) and extend from said surface (22) of the body (20) through the counterlectrode layer (25) and through the insulating layer (24) down to the bottom layer (23) and
that, in the direction parallel to the surface (22) of the body (20), the width (B1) of the pores (21) is larger than the free path of the electrons and smaller than twenty times the free path of the electrons, the free path of the electrons depending on the nature and on the pressure of the gas surrounding the arrangement.

27. An arrangement according to claim 26, characterized in
that, in a direction perpendicular to the surface (22), the depth (D2) of the pores (21) exceeds the width (B1) of said pores.

28. An arrangement according to claim 26 or 27, characterized in
that, in a direction perpendicular to the surface (22) of the body (20), the thickness (D1) of the insulating layer (24) is larger than the free path of the electrons and smaller than twenty times the free path of the electrons, the free path of the electrons depending on the nature and on the pressure of the gas surrounding the arrangement.

29. An arrangement according to claim 28, characterized in
that, in a direction perpendicular to the surface (22) of the body (20), the thickness (D1) of the insulating layer (24) is smaller than ten times the free path of the electrons, the free path of the electrons depending on the nature and on the pressure of the gas surrounding the arrangement.

30. An arrangement according to one of the claims 25 to 29, characterized in
that the pores (21) have been produced by anodizing or by means of an etching process.

31. An arrangement according to one of the claims 26 to 30, characterized in
that the thickness of the counterelectrode layer (25) is from 0.1 µm to 0.5 µm.

32. An arrangement according to one of the claims 26 to 31, characterized in
that the thickness of the insulating layer (24) is from 0.5 µm to 5 µm.

33. An arrangement according to one of the claims 26 to 33, characterized in
that the gas surrounding the arrangement is air, nitrogen or a noble gas at ambient pressure, and
that the width (B1) of the pores (21) is between 0.5 µm and 20 µm.

34. An arrangement according to one of the claims 26 to 33, characterized in
that the gas surrounding the arrangement is air, nitrogen or a noble gas, and
that the depth (D2) of the pores (21) is between 0.5 µm and 20 µm.

35. An arrangement according to one of the claims 26 to 34, characterized in
that the conductive bottom layer (23) consists of a metal or of a semiconductor material.

36. An arrangement according to claim 35, characterized in
that the conductive bottom layer (23) consists of silicon.

37. An arrangement according to one of the claims 26 to 36, characterized in
that the insulating layer (24) consists of SiO₂, N₃O₄, Al₂O₃ or of a plastic material.

38. An arrangement according to one of the claims 26 to 37, characterized in
that the counterelectrode layer (25) consists of metal or of polysilicon.

39. An arrangement according to one of the claims 26 to 38, characterized in
that, at least in the area of the condutive bottom layer (23), the pore wall is covered with an insulating layer (28) whose thickness is smaller than or equal to 1 µm.

## Revendications

1. Procédé pour la production de plasma, avec les étapes de procédé suivantes:
- préparation d'un corps microporeux,
-- qui a une résistance spécifique supérieure à 2·10⁻⁷ ohms·m, et
-- qui présente des pores remplis d'un gaz qui ont un diamètre de pore compris entre 1 nanomètre et 50 micromètres,
- réalisation de deux contacts distants l'un de l'autre, par lesquels peut être appliquée sur le corps microporeux une tension suffisante pour la production de plasma, et
- application aux contacts d'une tension suffisante pour la production de plasma qui est supérieure à la tension à laquelle se produit une électroluminescence.

2. Procédé suivant la revendication 1, caractérisé par le fait que le corps microporeux présente des pores réticulés.

3. Procédé suivant la revendication 1 ou 2, caractérisé par le fait que le corps microporeux présente des pores qui ont une diamètre de pore compris entre 10 nanomètres et 10 micromètres.

4. Procédé suivant l'une des revendications 1 à 3, caractérisé par le fait que le corps microporeux présente tant de grands pores que de petits pores dont les diamètres diffèrent l'un de l'autre de plus du facteur 2.

5. Procédé suivant l'une des revendications 1 à 4, caractérisé par le fait que le corps microporeux est réalisé en un matériau semi-conducteur poreux.

6. Procédé suivant la revendication 5, caractérisé par le fait que le corps microporeux est réalisé en silicium poreux.

7. Procédé suivant la revendication 6, caractérisé par le fait que l'étape de procédé de préparation du silicium microporeux comporte les étapes partielles suivantes:
- introduction d'une plaquette de silicium dans un bain d'acide, et
- anodisation de la plaquette de silicium dans le bain d'acide.

8. Procédé suivant la revendication 7, caractérisé par l'étape partielle supplémentaire suivante pour la préparation du silicium microporeux:
- illumination de la plaquette de silicium sur sa face anodique, au moins pendant une partie du temps pendant lequel la plaquette de silicium est placée et anodisée dans le bain d'acide, par laquelle le silicium monocristallin de la plaquette de silicium est transformée, au moins par endroits, en une couche de silicium microporeuse.

9. Procédé suivant l'une des revendications 7 ou 8, caractérisé par le fait que l'anodisation s'effectue à une intensité de courant de 2 à 500 mA/cm².

10. Procédé suivant l'une des revendications 7 à 9, caractérisé par le fait que le bain d'acide contient de 2 à 50 pour cent en poids d'acide fluorhydrique et se compose, pour le reste, d'éthanol et d'eau.

11. Procédé suivant l'une des revendications 7 à 9, caractérisé par le fait que la plaquette de silicium contient un adjuvant n.

12. Procédé suivant la revendication 11, caractérisé par le fait que l'adjuvant de la plaquette de silicium est choisi de telle sorte que sa résistance spécifique est comprise entre 1 et 10 ohms . cm.

13. Procédé suivant l'une des revendications 8 à 12, caractérisé par le fait que l'illumination s'effectue à l'aide d'une lampe au mercure ou d'une lampe halogène ou d'un laser.

14. Procédé suivant l'une des revendications 7 à 13, caractérisé par le fait que l'étape de procédé consistant à réaliser le second contact comprend la réalisation d'un contact ohmique sur la face arrière de la plaquette de silicium.

15. Procédé suivant l'une des revendications 7 à 14, caractérisé par le fait que l'étape de procédé consistant à réaliser le premier contact comprend l'application d'un contact en or.

16. Procédé suivant la revendication 15, caractérisé par le fait que l'épaisseur du contact en or est d'environ 120 nanomètres.

17. Procédé suivant l'une des revendications 7 à 16, caractérisé par le fait que l'étape de procédé consistant à réaliser le premier contact comprend l'application d'une couche d'oxyde mixte d'indium et d'étain.

18. Procédé suivant la revendication 17, caractérisé par le fait que l'épaisseur de la couche d'oxyde mixte d'indium et d'étain est d'environ 200 nanomètres.

19. Procédé suivant l'une des revendications 7 à 18, caractérisé par le fait que l'étape de procédé consistant à réaliser le contact comprend les étapes suivantes:
- application sur la couche de silicium microporeuse d'un premier contact au moins partiellement translucide, et
- réalisation d'un second contact pour la mise en contact d'une zone de la plaque de silicium au-dessous de la couche de silicium microporeuse.

20. Agencement pour la production de plasma, qui comporte les éléments suivants:
- un corps microporeux (1, 10),
-- qui a une résistance spécifique supérieure à 2·10⁻⁷ ohms·m, et
-- qui présente des pores remplis d'un gaz qui ont un diamètre de pore compris entre 1 nanomètre et 50 micromètres,
-- deux contacts (11, 12) distants l'un de l'autre, par lesquels peut être appliquée sur le corps microporeux (1, 10) une tension suffisante pour la production de plasma, et
- une source de tension pour l'application aux contacts (11, 12) d'une tension suffisante pour la production de plasma qui est supérieure à la tension à laquelle se produit une électroluminescence.

21. Agencement suivant la revendication 20, caractérisé par le fait que le corps microporeux (1, 10) présente des pores réticulés.

22. Agencement suivant la revendication 20 ou 21, caractérisé par le fait que le corps microporeux (1, 10) présente des pores qui ont une diamètre de pore compris entre 10 nanomètres et 10 micromètres.

23. Agencement suivant l'une des revendications 20 à 22, caractérisé par le fait que le corps microporeux (1, 10) présente tant de grands pores que de petits pores dont les diamètres diffèrent l'un de l'autre de plus du facteur 2.

24. Agencement suivant l'une des revendications 20 à 23, caractérisé par le fait que le corps microporeux (1, 10) est réalisé en un matériau semi-conducteur.

25. Agencement suivant la revendication 24, caractérisé par le fait que le corps microporeux (1, 10) est réalisé en silicium poreux.

26. Agencement suivant l'une des revendications 20 à 25, caractérisé par le fait
que le corps présente une couche de base conductrice (23), une couche isolante (24) disposée sur cette dernière et une couche de contre-électrode (25) disposée sur la couche isolante (24),
que les pores (21) se situent à l'endroit de la surface (22) du corps (20) et s'étendent en partant de la surface (22) du corps (20), à travers la couche de contre-électrode (25) et à travers la couche isolante (24), jusque dans la couche de base (23), et
que la largeur (B1) des pores (21), dans la direction parallèle à la surface (22) du corps (20), est plus grande que la longueur de trajectoire libre des électrons et plus petite que vingt fois la longueur de trajectoire libre des électrons, la longueur de trajectoire libre des électrons dépendant de la nature et de la pression du gaz entourant l'agencement.

27. Agencement suivant la revendication 26, caractérisé par le fait que la profondeur (D2) des pores, perpendiculaire à la surface (22), est plus grande que leur largeur (B1).

28. Agencement suivant la revendication 26 ou 27, caractérisé par le fait que l'épaisseur (D1) de la couche isolante (24), dans la direction perpendiculaire à la surface (22) du corps (20), est plus grande que la longueur de trajectoire libre des électrons et plus petite que vingt fois la longueur de trajectoire libre des électrons, la longueur de trajectoire libre des électrons dépendant de la nature et de la pression du gaz entourant l'agencement.

29. Agencement suivant la revendication 28, caractérisé par le fait que l'épaisseur (D1) de la couche isolante (24), dans la direction perpendiculaire à la surface (22) du corps (20), est plus petite que dix fois la longueur de trajectoire libre des électrons, la longueur de trajectoire libre des électrons dépendant de la nature et de la pression du gaz entourant l'agencement.

30. Agencement suivant l'une des revendications 25 à 29, caractérisé par le fait que les pores (21) sont réalisés par anodisation ou par un procédé de corrosion.

31. Agencement suivant l'une des revendications 26 à 30, caractérisé par le fait que l'épaisseur de la couche de contre-électrode (25) est de 0,1 µm à 0,5 µm.

32. Agencement suivant l'une des revendications 26 à 31, caractérisé par le fait que l'épaisseur de la couche isolante (24) est de 0,5 µm à 5 µm.

33. Agencement suivant l'une des revendications 26 à 32, caractérisé par le fait
que le gaz entourant l'agencement est de l'air, de l'azote ou un gaz noble à pression ambiante, et
que la largeur (B1) des pores (21) est comprise entre 0,5 µm et 20 µm.

34. Agencement suivant l'une des revendications 26 à 33, caractérisé par le fait
que le gaz entourant l'agencement est de l'air, de l'azote ou un gaz noble, et
que la profondeur (D2) des pores (21) est comprise entre 0,5 µm et 20 µm.

35. Agencement suivant l'une des revendications 26 à 34, caractérisé par le fait que la couche de base conductrice (23) est réalisée en un métal ou un matériau semi-conducteur.

36. Agencement suivant la revendication 35, caractérisé par le fait que la couche de base conductrice (23) est réalisée en silicium.

37. Agencement suivant l'une des revendications 26 à 36, caractérisé par le fait que la couche isolante (24) est réalisée en SiO₂, N₃O₄, Al₂O₃ ou en une matière plastique.

38. Agencement suivant l'une des revendications 26 à 37, caractérisé par le fait que la couche de contre-électrode (25) est réalisée en métal ou en polysilicium.

39. Agencement suivant l'une des revendications 26 à 38, caractérisé par le fait que la paroi de pore est, au moins à l'endroit de la couche de base conductrice (23), recouverte d'une couche isolante (28) dont l'épaisseur est inférieure ou égale à 1 µm.
